# FASCICULE DE BREVET EUROPEEN

(11) **EP 1 760 042 B1**
(45) Date de publication et mention de la délivrance du brevet: **29.05.2013**
(21) Numéro de dépôt: 06300836.1
(22) Date de dépôt: 28.07.2006
(51) Int. Cl.: B81C 1/00, H05K 3/34

(54) **Procédé pour la réalisation de moyens de connexion et/ou de soudure d'un composant**
Herstellungsverfahren von Verbindungs- und/oder Bondmitteln eines Bauelements
Method of manufacturing connecting and/or bonding means of a device.

(30) Priorité: 30.08.2005 FR 0552611
(43) Date de publication de la demande: 07.03.2007
(73) Titulaire: Commissariat à l'Énergie Atomique et aux Énergies Alternatives, 75015 Paris (FR)
(72) Inventeur: Marion, François, 38950, Saint Martin le Vinoux (FR)
(74) Mandataire: Vuillermoz, Bruno

(56) Documents cités:
- US-A- 5 547 902
- US-B1- 6 238 951

## Description

### DOMAINE DE L'INVENTION

L'invention concerne le domaine de la microélectronique, et plus spécifiquement celui des techniques d'hybridation et de soudure ou de scellement par matériau de soudure fusible.

### ETAT ANTERIEUR DE LA TECHNIQUE

L'évolution de la technologie des circuits intégrés a permis d'aboutir à la miniaturisation poussée et notamment à réaliser des microcomposants.

Parmi les progrès techniques ayant permis une telle miniaturisation, figure l'hybridation de puces au moyen de billes de soudure conductrices sur des substrats multicouches, destinés à réaliser des interconnections entre les puces. Cette technologie, mieux connue sous l'expression anglo-saxonne « *flip-chip* », permet ainsi d'hybrider des centaines de puces sur des substrats céramiques.

Elle met en oeuvre des microbilles conductrices, en général réalisées en un matériau à bas point de fusion, tel que SnPb, In, AgCuSn, et est aujourd'hui largement maîtrisée.

Dans le même domaine, mais dans une application différente, un certain nombre de ces microcomposants sont encapsulés au sein d'une structure de type boîtier ou capot de protection ou équivalent, permettant d'assurer une protection contre les chocs, la corrosion, les rayons électromagnétiques parasites etc...

Au surplus, de tels boîtiers ou capots de protection assurent également la possibilité pour ces microcomposants de travailler sous vide, ou sous atmosphère contrôlée (pression, gaz neutre, etc..) ou de manière étanche par rapport à l'atmosphère ambiante.

Un tel boîtier ou capot est classiquement scellé au moyen d'un joint ou cordon de scellement, rapporté à la périphérie du composant en question, en général au niveau d'une zone ou surface de mouillabilité, également dénommée surface d'accroche.

Plus fréquemment, les composants concernés, qu'il s'agisse de micro-capteurs, micro-actuateurs, MEMS (*micro electro mechanical system),* etc..., nécessitent donc pour leur réalisation la mise en oeuvre d'éléments de soudure et/ou de connexion de hauteurs différentes, mesurées par rapport à un référentiel constitué par la face supérieure du substrat sur lequel sont mis en place ou rapportés les microcomposants en question.

Plusieurs technologies sont aujourd'hui connues, qui permettent la réalisation de tels cordons de soudure ou le dépôt de billes ou microbilles d'hybridation, et donc de connexion.

On peut ainsi les techniques suivantes :
- évaporation à travers un masque et soudure ;
- « solder jetting » ou jet de gouttelettes de soudure à l'instar des imprimantes à jet d'encre :;
- électrolyse ;
- sérigraphie.

Le document US 6 238 951 décrit par exemple la réalisation de tels cordons de soudure.

Cependant, toutes ces techniques nécessitent systématiquement au moins deux opérations différentes pour aboutir à des éléments de soudure et de connexion de hauteur différente.

Au surplus, la plupart de ces technologies s'avère d'un coût de réalisation élevé, notamment en raison des manipulations qu'elles engendrent.

Le document US 5 547 902 décrit un procédé pour la réalisation de moyens de connexion d'un composant, mettant en oeuvre une couche en matériau ductile, et une étape d'emboutissage de ladite couche.

L'objet de la présente invention est justement de s'affranchir de la mise en oeuvre de deux étapes consécutives pour permettre la réalisation d'éléments de soudure de hauteur différente, et corollairement, selon un coût de fabrication réduit.

### EXPOSE DE L'INTENTION

Ainsi, la présente invention vise un procédé de réalisation de moyens de connexion et/ou de soudure ou de scellement, d'un composant présent sur un substrat.

Ce procédé consiste :
- à réaliser sur le substrat des surfaces ou zones de mouillabilité;
- à déposer sur les surfaces ou zone de mouillabilité une couche en un matériau ductile, le cas échéant, conducteur de l'électricité ;
- à emboutir la couche ainsi réalisée au moyen d'une matrice gravée, dont les gravures sont fonction de la forme que l'on souhaite conférer auxdits moyens de connexion et/ou de soudure.

En d'autres termes, l'invention consiste ni plus ni moins qu'à mettre en oeuvre durant le procédé de réalisation une étape de moulage d'un matériau suffisamment ductile pour permettre sa déformation, notamment à température ambiante à l'instar des technologies largement connues de frappage des pièces de monnaie, ou à une température proche de la température de fusion dudit matériau, voire même à une température supérieure à cette dernière.

En effet, il convient de conférer à la matrice d'emboutissage ou de frappage les formes souhaitées, et notamment les profondeurs différentes souhaitées pour permettre d'aboutir à des hauteurs différenciées des moyens de soudure ou de connexion.

Bien évidemment, la hauteur de la couche de matériau ductile préalablement déposée est suffisante pour permettre un emboutissage correct par la matrice, et corollairement la réalisation de hauteurs de matériau différentes.

Typiquement, les zones ou surfaces de mouillabilité sont réalisées en or après réalisation d'une couche barrière typiquement réalisée en nickel.

Selon une première forme de réalisation de l'invention, ces zones ou surfaces de mouillabilité sont réalisées exactement en fonction du profil souhaité des moyens de soudure ou de connexion, c'est à dire occupent une surface sur le substrat correspondant sensiblement à la surface occupée sur le même substrat par les éléments de connexion et/ou de soudure résultant du procédé de l'invention.

Selon une autre forme de réalisation de l'invention, ces zones ou surfaces de mouillabilité recouvrent l'intégralité du substrat, et la couche destinée à constituer ces surfaces de mouillabilité est ôtée du substrat entre les zones recevant le matériau ductile par gravure, après dépôt de ladite couche en matériau ductile, ce dernier faisant fonction de masque lors de l'opération de gravure de la couche constitutive des surfaces de mouillabilité.

Enfin, et selon l'invention, on confère au matériau ductile après formatage ou frappage, une forme correspondante à la forme souhaitée par refusion sous une température supérieure à la température de fusion du matériau ductile.

Notamment, par ce biais, on confère une forme en billes ou, lorsque l'on souhaite disposer d'un cordon de scellement, on confère une forme globalement cylindrique à la couche de matériau ductile ainsi déposée.

### BREVE DESCRIPTION DES DESSINS

La manière dont l'invention peut être réalisée et les avantages qui en découlent ressortiront mieux des exemples de réalisation qui suivent donnés à titre indicatif et non limitatif à l'appui des figures annexées.
Les figures 1a à 1d sont des représentations schématiques du principe mis en oeuvre par la présente invention.
La figure 2 est une représentation schématique en section visant à illustrer l'étape de frappage de matériau ductile selon une première forme de réalisation.
Les figures 3a et 3b sont des vues analogues à la figure 2, mais d'une autre forme de réalisation.
Les figures 4a à 4e sont des représentations schématiques respectivement vues de dessus (figure 4a) et en section (figures 4b à 4d) de la mise en oeuvre du procédé de l'invention pour la fabrication de billes sur un wafer CMOS.

### DESCRIPTION DETAILLEE DE L'INVENTION

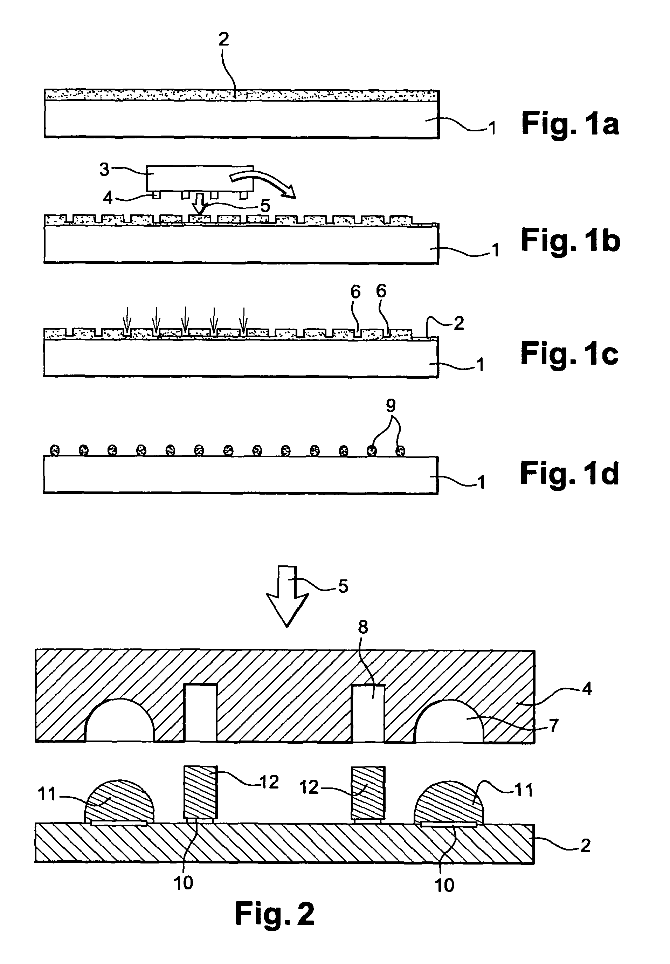

On a donc schématiquement représenté en relation avec les figures 1a à 1d le principe général sous-tendant le procédé conforme à l'invention.

Selon celui-ci, on dispose d'un substrat **1** typiquement réalisé en silicium. Ce substrat est par exemple constitué d'une galette ou wafer selon l'expression anglo-saxonne consacrée, d'une dimension de 300 mm par exemple.

Puis on procède au dépôt ou au report d'une couche d'un matériau de soudure **2** sur une tranche. Ce matériau est ductile, et est typiquement constitué d'indium ou d'un alliage étain/plomb, ou d'un alliage AgCuSn.

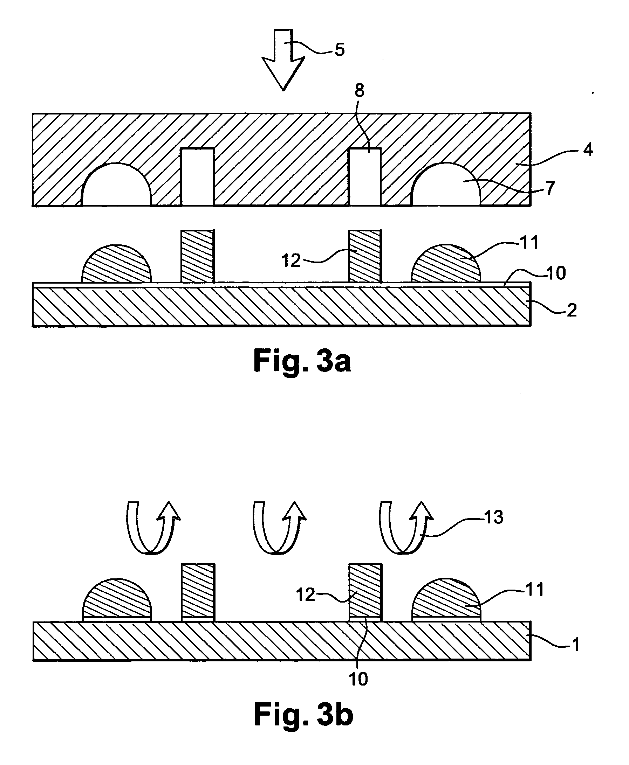

On procède alors à une étape d'emboutissage (figure 1b) au moyen d'une matrice **3** pourvue de poinçons **4,** ou dont les formes **7, 8** ménagées en son sein définissent entre elles des poinçons **4** (voir figure 2 et figure 3a).

Cette matrice fonctionne par indexation : la matrice est dans ce cas de la taille d'un champ de photocomposition ; elle est appliquée sur chaque champ et est indexée au pas du champ (procédé « *step and repeat* »).

Cependant, cette matrice peut aussi fonctionner selon une tranche entière selon un mode global : la matrice est alors de la même taille que la plaque de substrat ou wafer **1,** et l'opération d'emboutissage est réalisée en une seule opération.

La matrice 3 est actionnée par une presse automatique ou manuelle pour venir emboutir selon la flèche **5** ladite couche de matériau ductile **2.**

A cet effet, on enduit la paroi inférieure des formes **7, 8** ainsi que la face inférieure de la matrice d'une couche anti-adhésive, par exemple réalisée en PTFE (polytétrafluoroéthylène), puis on applique ladite matrice sur la surface de la couche de matériau ductile **2** à imprimer avec une pression P **4.** On retire alors la matrice définissant ainsi une succession de formes, fonction des formes **7** et **8** de ladite matrice.

Cette matrice est avantageusement réalisée en silicium. En effet, on observe que la mise en oeuvre d'un tel matériau permet d'aboutir à des motifs d'une grande finesse, permettant ce faisant un coût de réalisation réduit des moules par photolithographie et gravure chimique classiques, et notamment la réalisation de motifs naturellement en forme de trapèze, favorisant les opérations de démoulage.

Après l'opération de démoulage, certaines zones en creux sont susceptibles de présenter des résidus issus de soudure, que l'on ôte par gravure.

Enfin (figure 1d) on remet les billes en forme de manière classique par refusion des éléments de soudure, c'est-à-dire par élévation de la température selon une température supérieure à la température de fusion dudit matériau ductile.

Par phénomène naturelle de réduction de la tension superficielle, la forme en bille est adoptée, ou, lorsque l'on met en oeuvre un cordon de soudure, une section sensiblement circulaire résulte de la refusion.

Les éléments de soudure, qu'il s'agisse de cordon de scellement ou de billes ou microbilles de conduction, également de scellement, sont rapportés sur une surface ou zone de mouillabilité.

Pour ce faire, préalablement au dépôt de la couche de soudure **2** on procède à la réalisation d'une couche barrière en nickel, notamment par voie électroless, au niveau de plots ouverts en suite des opérations de fonderie aboutissant à la réalisation du wafer CMOS en silicium.

On rapporte sur cette couche barrière en nickel une couche d'or (l'or faisant fonction de métal d'accroche, donc de surface de mouillabilité) et ce, selon des procédés connus par ailleurs et tel que par exemple développé par la société PACTECH.

Selon l'invention, deux alternatives sont possibles. La première consiste en la réalisation de cette double couche nickel/or au niveau des seuls lieux définitifs de positionnement des éléments de soudure, qu'il s'agisse d'un cordon ou de microbilles (figure 2).

Dans ce cas, les zones de mouillabilité sont prégravées et l'opération de dépôt et de formatage ou de frappage de la couche de matériau ductile **2** destiné à constituer les éléments de soudure ou de connexion s'effectue tel que précédemment décrit.

Selon une autre forme de réalisation représentée en relation avec les figures 3a et 3b, toute la surface supérieure du wafer, à l'exception bien évidemment de celle destinée à recevoir le composant ou le microcomposant, est revêtu de la couche nickel/or **10.** Dans ce cas, après frappage de la couche de matériau ductile **2** selon la forme souhaitée, on procède par gravure à l'enlèvement de la double couche barrière nickel/or au niveau des zones dépourvues de ces éléments de soudure.

Dans les deux cas, il est possible que subsiste après l'étape d'emboutissage, une pellicule de matériau ductile entre les formes réalisées. Il faut alors prévoir une étape de gravure de ces résidus. A cet effet, toute la surface est rafraîchie par gravure d'une fine couche du matériau ductile, tant sur les formes qu'entre les formes.

Dans la seconde forme de réalisation, cette gravure est suivie par une seconde gravure, qui supprime la couche barrière entre les formes.

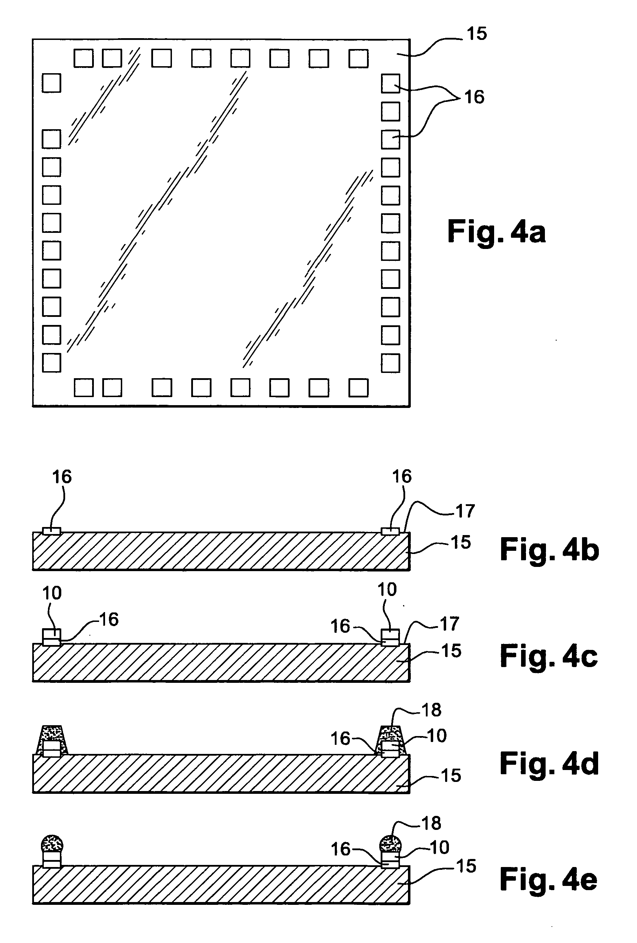

On a décrit en relation avec la figure 4 un mode plus précis de réalisation de l'invention. Celui-ci met en oeuvre un wafer CMOS **15** en sortie de fonderie silicium de 300 mm sur 300 mm. Il comporte un certain nombre de plots d'aluminium **16**, donc conducteurs, espacés de 100 µm les uns des autres et répartis à la périphérie du wafer. La surface de la puce est de 1cm², et la hauteur des plots de 50µm.

Ainsi, pour une puce de 1 cm de coté (surface = 10⁸ µm²), on dépose une couche d'indium de 1,8 µm d'épaisseur. Ce faisant, on dispose d'un volume de matériau ductile de 1,8 . 10⁸ µm³. Cette puce est alors emboutie par une matrice dessinée afin d'obtenir 1000 plots de 60 x 60 µm. La soudure passant pratiquement entièrement dans les plots, ces derniers ont une hauteur d'environ 50 µm.

On observe donc tout l'intérêt du procédé conforme à l'invention dans la mesure où, en une seule opération, il est possible d'obtenir les éléments de soudure de taille différente, ce que l'on ne savait pas faire jusqu'alors. Au surplus, les techniques de mise en oeuvre, et notamment l'impression directe, mais également l'évaporation électrolyse permettent de ne pas obérer les coûts de revient de tels composants.

Ce faisant, la fabrication des microcomposants actifs, notamment électroniques, est envisageable par ce procédé, et notamment les matrices de détection de rayonnements électromagnétiques, et plus particulièrement infrarouges, munies ou non de compensation de dilatation inhérent au changement de température de fonctionnement.

Les cordons de scellement réalisés concomitamment avec les billes de connexion pour les scellements hermétiques sont également parfaitement réalisables, notamment pour la mise en oeuvre de capot ou boîtier de protection pour le confinement hermétique du composant.

Enfin l'invention s'applique également à la préparation des billes d'hybridation et de manière générale à la réalisation de tous les composants hybridés, qu'il s'agisse de composants fonctionnant dans le domaine de l'optique, des rayons X, ou de l'hybridation sur ruban flexible, sur céramique, sur « *multi chip module* », sur board : COB « *chip on board »* (circuit imprimé) ou sur verre COG « *chip on glass* ».

## Revendications

1. Procédé pour la réalisation de moyens de connexion et/ou de soudure ou de scellement, d'un composant présent sur un substrat **1, *caractérisé* en ce qu'**il consiste :
- à réaliser sur le substrat **1** des surfaces ou zones de mouillabilité **10** ;
- à déposer sur lesdites surfaces ou zones de mouillabilité **10** réalisées sur le substrat **1** une couche **2** en un matériau ductile, le cas échéant, conducteur de l'électricité ;
- à emboutir la couche **2** ainsi réalisée au moyen d'une matrice gravée **3,** dont les gravures sont fonction de la forme que l'on souhaite conférer auxdits moyens de connexion et/ou de soudure.

2. Procédé pour la réalisation de moyens de connexion et/ou de soudure ou de scellement, d'un composant selon la revendication 1, ***caractérisé* en ce qu'**il est procédé à une étape de gravure du matériau résiduel entre les formes ainsi réalisées.

3. Procédé pour la réalisation de moyens de connexion et/ou de soudure ou de scellement, d'un composant selon l'une des revendications 1 et 2, ***caractérisé* en ce que** les profondeurs des gravures réalisées au sein de la matrice sont identiques ou différentes.

4. Procédé pour la réalisation de moyens de connexion et/ou de soudure ou de scellement, d'un composant selon l'une des revendications 1 à 3, ***caractérisé* en ce que** les zones ou surfaces de mouillabilité **10** sont réalisées en or après réalisation d'une couche barrière typiquement réalisée en nickel.

5. Procédé pour la réalisation de moyens de connexion et/ou de soudure ou de scellement, d'un composant selon l'une des revendications 1 à 4, ***caractérisé* en ce que** les zones ou surfaces de mouillabilité **10** sont réalisées en fonction du profil souhaité des moyens de soudure ou de connexion, et **en ce qu'**elles occupent une surface sur le substrat correspondant sensiblement à la surface occupée sur le même substrat par les éléments de connexion et/ou de soudure résultant dudit procédé.

6. Procédé pour la réalisation de moyens de connexion et/ou de soudure ou de scellement, d'un composant selon l'une des revendications 1 à 4, ***caractérisé* en ce que** les zones ou surfaces de mouillabilité **10** sont réalisées de telle manière à recouvrir l'intégralité du substrat **1,** et **en ce que** la ou les couches destinées à constituer ces zones ou surfaces de mouillabilité **10** sont ôtées du substrat entre les zones recevant le matériau ductile par gravure, après dépôt de ladite couche **2** en matériau ductile, ce dernier faisant fonction de masque lors de l'opération de gravure de la couche constitutive des surfaces de mouillabilité.

7. Procédé pour la réalisation de moyens de connexion et/ou de soudure ou de scellement, d'un composant selon l'une des revendications 1 à 6, ***caractérisé* en ce que** la forme souhaitée des éléments de connexion et/ou de soudure est conférée par opération de refusion sous une température supérieure à la température de fusion du matériau ductile.

## Patentansprüche

1. Verfahren zur Herstellung von Anschluss- und/oder Löt- oder Einkapselungsmitteln für ein Bauteil, das auf einem Substrat 1 vorhanden ist, **dadurch gekennzeichnet, dass** es darin besteht:
- auf dem Substrat 1 Benetzbarkeitsflächen oder -zonen 10 herzustellen;
- auf diesen auf dem Substrat 1 hergestellten Benetzbarkeitsflächen oder -zonen eine Schicht 2 aus einem duktilen, gegebenenfalls elektrisch leitenden Material abzuscheiden;
- Pressen der so hergestellten Schicht 2 mittels eines geprägten Gesenks 3, dessen Prägungen von der Form abhängen, die den Anschluss - und/oder Lötmitteln verliehen werden sollen.

2. Verfahren nach Anspruch 1, zur Herstellung von Anschluss- und/oder Löt- oder Einkapselungsmitteln für ein Bauteil, **dadurch gekennzeichnet, dass** es ein Verfahren mit einem Prägeschritt des Restmaterials zwischen den so hergestellten Formen ist.

3. Verfahren nach einem der Ansprüche 1 oder 2, zur Herstellung von Anschluss - und/oder Löt- oder Einkapselungsmitteln für ein Bauteil, **dadurch gekennzeichnet, dass** die Tiefen der im Gesenk hergestellten Prägungen gleich oder unterschiedlich sind.

4. Verfahren nach einem der Ansprüche 1 bis 3, zur Herstellung von Anschluss - und/oder Löt- oder Einkapselungsmitteln für ein Bauteil, **dadurch gekennzeichnet, dass** die Benetzbarkeitszonen oder -flächen 10 bei oder nach einer Herstellung einer typischerweise aus Nickel hergestellten Sperrschicht hergestellt werden.

5. Verfahren nach einem der Ansprüche 1 bis 4, zur Herstellung von Anschluss - und/oder Löt- oder Einkapselungsmitteln für ein Bauteil, **dadurch gekennzeichnet, dass** die Benetzbarkeitszonen oder -flächen 10 in Abhängigkeit vom gewünschten Profil der Löt- oder Anschlussmittel hergestellt werden, und dass sie eine Fläche auf dem Substrat einnehmen, die im Wesentlichen der Fläche entspricht, die auf eben diesem Substrat von den Anschluss- und/oder Lötelementen eingenommen wird, die sich aus dem Verfahren ergeben.

6. Verfahren nach einem der Ansprüche 1 bis 4, zur Herstellung von Anschluss - und/oder Löt- oder Einkapselungsmitteln für ein Bauteil, **dadurch gekennzeichnet, dass** die Benetzbarkeitszonen oder -flächen 10 so hergestellt werden, dass sie das gesamte Substrat 1 bedecken, und dass die Schicht/en, die dazu bestimmt ist/sind, die Benetzbarkeitszonen oder -flächen 10 zu bilden, vom Substrat zwischen den das duktile Material durch Prägung erhaltenden Zonen nach Abscheidung der Schicht 2 aus duktilem Material entfernt werden, wobei Letzteres beim Prägevorgang der die Benetzbarkeitsflächen bildenden Schicht als Maske dient.

7. Verfahren nach einem der Ansprüche 1 bis 6, zur Herstellung von Anschluss - und/oder Löt- oder Einkapselungsmitteln für ein Bauteil, **dadurch gekennzeichnet, dass** die gewünschte Form der Anschluss- und/oder Lötmittel durch einen erneuten Schmelzvorgang unter einer Temperatur verliehen wird, die höher ist als die Schmelztemperatur des duktilen Materials.

## Claims

1. A method for producing means of connecting and/or soldering or sealing a component on a substrate 1, **characterised in that** it involves:
- realizing wettable surfaces or areas 10 on the substrate 1 ;
- depositing on said wettable surfaces or areas 10 realized on the substrate 1 a layer 2 made of a ductile material which, if applicable, conducts electricity;
- stamping the layer 2 thus produced by means of an etched die 3, the etching depending on the shape that one wishes to give said means of connecting and/or soldering.

2. A method for producing means of connecting and/or soldering or sealing a component as claimed in claim 1, **characterised in that** an etching process is performed to remove the residual material between the shapes thus produced.

3. A method for producing means of connecting and/or soldering or sealing a component as claimed in either claim 1 or 2, **characterised in that** the depths of etching in the die are identical or different.

4. A method for producing means of connecting and/or soldering or sealing a component as claimed in claims 1 to 3, **characterised in that** the wettable areas or surfaces 10 are made of gold after producing a barrier layer typically made of nickel.

5. A method for producing means of connecting and/or soldering or sealing a component as claimed in either claim 1 to 4, **characterised in that** the wettable surfaces or areas 10 are made depending on the desired profile of the means of soldering or connecting and **in that** they occupy a surface on the substrate that is substantially equivalent to the surface occupied on the same substrate by the connection and/or solder elements resulting from said method.

6. A method for producing means of connecting and/or soldering or sealing a component as claimed in either claims 1 to 4, **characterised in that** the wettable surfaces or areas 10 are produced so that they cover all substrate 1 and **in that** the layer or layers intended to constitute these wettable areas or surfaces 10 are removed from the substrate between the areas that accommodate the ductile material by etching after deposition of said layer 2 made of a ductile material, the latter acting as a mask during etching of the layer that constitutes the wettable surfaces.

7. A method for producing means of connecting and/or soldering or sealing a component as claimed in any of claims 1 to 6, **characterised in that** the desired shape of the connection and/or solder elements is produced by remelting at a temperature in excess of the melting temperature of the ductile material.
